(19) Europäisches Patentamt

European Patent Office

Office européen des brevets

(11) **EP 1 213 591 B1**

(12) **EUROPÄISCHE PATENTSCHRIFT**

(45) Veröffentlichungstag und Bekanntmachung des Hinweises auf die Patenterteilung:
**10.05.2006 Patentblatt 2006/19**

(51) Int Cl.:
*G01R 33/3815* *(2006.01)* *H01F 6/02* *(2006.01)*

(21) Anmeldenummer: **01121214.9**

(22) Anmeldetag: **05.09.2001**

(54) **Magnetanordnung mit einem aktiv abgeschirmten supraleitenden Magnetspulensystem und einem zusätzlichen Strompfad zur Streufeldunterdrückung im Quenchfall**

Magnet arrangement with an actively screened superconducting coil system and an additional current path for the suppression of stray fields during a quench

Agencement d'aimants avec un système de bobines supraconductrices avec blindage actif et un chemin de courant supplémentaire pour la suppression de champs de fuite pendant la transition de l'état supraconducteur à l'état normal

(84) Benannte Vertragsstaaten:
**CH DE FR GB LI**

(30) Priorität: **05.12.2000 DE 10060284**

(43) Veröffentlichungstag der Anmeldung:
**12.06.2002 Patentblatt 2002/24**

(73) Patentinhaber: **Bruker BioSpin AG**
**8117 Fällanden (CH)**

(72) Erfinder:
• **Schauwecker, Robert**
**8032 Zürich (CH)**
• **Bovier, Pierre-Alain**
**8051 Zürich (CH)**
• **Amann, Andreas**
**8008 Zürich (CH)**

(74) Vertreter: **Kohler Schmid Möbus**
**Patentanwälte**
**Ruppmannstrasse 27**
**70565 Stuttgart (DE)**

(56) Entgegenhaltungen:
**EP-A- 0 138 270        EP-A- 0 468 415**
**US-A- 5 644 233**

**EP 1 213 591 B1**

**Beschreibung**

Die Erfindung betrifft eine Magnetanordnung mit einem aktiv abgeschirmten, supraleitenden Magnetspulensystem zur Erzeugung eines Magnetfeldes in Richtung einer *z*-Achse in einem auf der *z*-Achse um *z* = 0 angeordneten Arbeitsvolumen und mit einer Mehrzahl von Schutzelementen zum Schutz des supraleitenden Magnetspulensystems im Falle eines Zusammenbruchs der Supraleitung im Magnetspulensystem, d.h. im Falle eines Quenchs, wobei das supraleitende Magnetspulensystem ein radial inneres Teilspulensystem und ein radial äußeres Teilspulensystem umfasst, welche elektrisch in Serie zusammengeschaltet und zueinander koaxial angeordnet sind und im Arbeitsvolumen je ein Magnetfeld mit entgegengesetzter Richtung entlang der z-Achse erzeugen, wobei der supraleitende Strompfad des Magnetspulensystems in mehrere Abschnitte unterteilt ist, welche mit jeweils mindestens einem der Schutzelemente elektrisch parallel geschaltet sind, wobei mindestens einer dieser Abschnitte sowohl Windungen des radial inneren Teilspulensystems als auch Windungen des radial äußeren Teilspulensystems umfasst.

Eine Magnetanordnung mit einem aktiv abgeschirmten Magnetspulensystem mit einem radial inneren und einem radial äußeren Teilspulensystem, wobei das Magnetspulensystem in mehrere Abschnitte unterteilt ist, die jeweils aus Windungen des inneren und Windungen des äußeren Teilspulensystems bestehen, derart, dass das Dipolmoment eines jeden dieser Abschnitte praktisch Null beträgt und jeder der Abschnitte mit einem Schutzelement parallel geschaltet ist, ist bekannt aus der US-A 5'644'233. Dieses Dokument offenbart eine Magnetanordnung gemäß dem Oberbegriff des Auspruchs 1.

Das Einsatzgebiet von supraleitenden Magneten umfasst verschiedene Anwendungsfelder. Dazu gehören insbesondere Hochfeldanwendungen, beispielsweise für Magnetresonanzverfahren. Solche Hochfeldmagneten erzeugen typischerweise auch ein beträchtliches Streufeld, was für die Umgebung des Magneten ein Gefahrenpotential darstellt. Diesem Problem kann begegnet werden, indem der Magnet mit einer aktiven Abschirmung ausgerüstet wird, also mit einer zusätzlichen supraleitenden Spule, welche mit der Hauptspule des Magneten in Serie geschaltet ist, aber ein Feld mit entgegengesetzter Polarität erzeugt.

Neben den starken Streufeldern stellt auch die Gefahr eines plötzlichen Zusammenbruchs der Supraleitung (=Quench) ein Problem bei supraleitenden Hochfeldmagneten dar. Um den supraleitenden Draht des Magneten im Falle eines Quenchs vor Überhitzung und Zerstörung zu schützen, besitzen supraleitende Magneten im Allgemeinen eine Vorrichtung, welche den Magnetstrom aus den im Verlaufe eines Quenchs resisvit gewordenen Spulenabschnitten über Schutzelemente, beispielsweise Widerstände, ableitet. Bei aktiv abgeschirmten Magneten kann eine solche Quenchschutzvorrichtung nun zu folgendem Problem führen: Falls beispielsweise die Abschirmspule gequencht hat, fließt der Strom aus der Abschirmung über die parallelgeschalteten Schutzelemente ab, während in der Hauptspule im Wesentlichen noch der ursprüngliche Magnetstrom fließt. Dies führt kurzfristig zu einer massiven Überhöhung des Streufeldes der Magnetanordnung, verglichen mit dem Streufeld im Betriebszustand.

In einer Anordnung gemäß US-A 5'644'233 wird das Problem einer möglichen Streufeldüberhöhung während eines Quenchs dadurch behoben, dass die Spulenabschnitte, welchen je ein gemeinsames Schutzelement parallelgeschaltet ist, jeweils aus Teilen der Hauptspule und der Abschirmspule zusammengesetzt werden, derart, dass das Dipolmoment jedes dieser Abschnitte im Betriebszustand klein ist. Falls in einem solchen Abschnitt ein Quench ausbricht und dadurch der Strom lokal reduziert wird, ändert sich daher das Dipolmoment der Magnetanordnung höchstens geringfügig, weshalb sich auch das Streufeld nicht wesentlich erhöhen kann.

Eine solche Lösung, bei welcher sämtliche mit Schutzelementen überbrückten Spulenabschnitte ein verschwindendes Dipolmoment aufweisen, ist insbesondere bei Hochfeldmagneten nicht immer zu verwirklichen. Dies vor allem aus zwei Gründen: Erstens muss für jeden Abschnitt eine supraleitende Verbindung zwischen den Anteilen aus der Hauptspule und den Abschirmungsanteilen gelegt werden, was bei einer feinen Unterteilung des Magneten in viele Abschnitte produktionstechnisch schwierig ist. Zweitens können die Hauptspulen- und Abschirmungsanteile hinsichtlich ihres Dipolmomentes nicht beliebig genau aufeinander abgestimmt werden, weil Anfang und Ende der Abschnitte nicht inmitten eines Wickelpakets liegen können, sondern nur am Ende einer ganzen Spulenlage. Somit ist in typischen Hochfeldmagneten nicht zu vermeiden, dass einige der, mit Schutzelementen überbrückten, Abschnitte ein erheblich von Null verschiedenes Dipolmoment aufweisen, was im Falle eines Quenchs in einem dieser Abschnitte zu einer deutlichen Änderung des Streufeldes der Magnetanordnung führen kann.

Die EP 0 468 415 A2 beschreibt eine Magnetanordnung mit einer inneren, supraleitenden Hauptfeldspule, einer zu dieser in Serie geschalteten äußeren, supraleitenden Abschirmspule mit gegenläufiger Stromrichtung und mit wenigstens einem elektrisch leitfähigen Ring im Außenbereich der Magnetanordnung. Im Falle einer Änderung des Stromflusses in den supraleitenden Spulen, etwa im Falle eines Quenchs, wird im Ring ein Strom induziert, dessen Magnetfeld denjenigen Magnetfeldern entgegen wirkt, die durch Induktionsströme in leitfähigen Teilen der Magnetanordnung erzeugt werden. Dadurch wird das Streufeld im Quenchfall im Wesentlichen konstant gehalten.

Aufgabe der vorliegenden Erfindung ist es demgegenüber, in einer Magnetanordnung, in welcher nicht alle, mit einem Schutzelement überbrückten, Abschnitte ein verschwindendes Dipolmoment aufweisen, die Gefahr einer Überhöhung des Streufeldes im Falle eines Quenches der Magnetanordnung wesentlich zu reduzieren.

Erfindungsgemäß wird diese Aufgabe dadurch gelöst, dass mindestens ein zusätzlicher, in sich geschlossener Strompfad vorgesehen ist, welcher eine nicht verschwindende Flächenwindungszahl und mit mindestens einem Abschnitt $Ai$ eine von Null verschiedene induktive Kopplung $L_{Ai \leftrightarrow C3}$ aufweist, insbesondere derart, dass der Kopplungskoeffizient

$$K_i = \frac{L_{Ai \leftrightarrow C3}}{\sqrt{L_{Ai} L_{C3}}}$$

größer als 0.01 ist, wobei $L_{Ai}$ beziehungsweise $L_{C3}$ die Eigeninduktivitäten des Abschnitts $Ai$ beziehungsweise des zusätzlichen Strompfades $C3$ bezeichnen dass mindestens einer der Abschnitte, welche mit dem zusätzlichen Strompfad eine wesentlich von Null verschiedene induktive Kopplung aufweisen, außerdem ein wesentlich von Null verschiedenes magnetisches Dipolmoment besitzt, und dass der Strom, welcher im Falle eines Quenchs dieses Abschnitts im zusätzlichen Strompfad induziert wird, ein magnetisches Dipolmoment erzeugt, welches im Wesentlichen demjenigen entspricht, welches dieser Abschnitt vor dem Quench aufwies.

Dadurch wird gewährleistet, dass das magnetische Dipolmoment der Magnetanordnung - und somit deren Streufeld - bei einem Quench in jenem Abschnitt erhalten bleibt.

Einerseits wird das Dipolmoment der Abschnitte, welche mit einem Schutzelement überbrückt werden, durch Kombination von Spulenanteilen aus der Hauptspule und der Abschirmspule so weit wie möglich reduziert. Andererseits ist ein zusätzlicher, vom Magnetspulensystem getrennter, Strompfad mit nicht verschwindender Flächenwindungszahl vorgesehen, welcher mit mindestens einem jener Abschnitte, deren Dipolmoment deutlich von Null verschieden ist, eine induktive Kopplung aufweist. Im Falle eines Quenchs in einem dieser Abschnitte wird so im zusätzlichen Strompfad ein Strom induziert, welcher die im Verlaufe des Quenchs auftretende Veränderung des Dipolmomentes der Magnetanordnung kompensiert und somit das Streufeld während des Quenchprozesses weitgehend konstant hält oder sogar zusätzlich reduziert.

Der Vorteil einer erfindungsgemäßen Anordnung besteht darin, dass bei der Bildung der, mit einem Schutzelement überbrückten, Abschnitte die Forderung nach einem verschwindenden Dipolmoment der Abschnitte nicht mehr notwendigerweise vollständig erfüllt werden muss, und dass dennoch ein guter Schutz vor Streufeldüberhöhungen während eines Quenchs der Magnetanordnung gewährleistet ist. Dadurch wird die Auslegung der Quenchschutzvorrichtung flexibler und sie kann beispielsweise produktionsfreundlicher ausgelegt oder für einen optimalen Schutz der Spule vor Überhitzung während eines Quenchs dimensioniert werden.

Besonders bevorzugt ist eine Ausführungsform der erfindungsgemäßen Magnetanordnung, bei der das radial innere und äußere Teilspulensystem näherungsweise entgegengesetzt gleich große magnetische Dipolmomente aufweisen. Eine solche Magnetanordnung ist optimal magnetisch abgeschirmt, d.h. sie besitzt aufgrund des im Wesentlichen verschwindenden magnetischen Dipolmomentes des Gesamtsystems ein sehr kleines Streufeld. In einer solchen Anordnung wäre es besonders schwierig, allein durch geeignete Wahl der, durch ein Schutzelement überbrückten, Abschnitte die niedrigen Streufeldwerte auch während eines Quenchs aufrecht zu erhalten.

Besonders vorteilhaft ist auch eine Ausführungsform der erfindungsgemäßen Magnetanordnung, bei der die Magnetanordnung Teil einer Apparatur zur hochauflösenden Magnetresonanzspektroskopie ist. Da für solche Magnetanordnungen das radial innere Teilspulensystem aufgrund der benötigten hohen Feldstärken im Allgemeinen ein sehr großes Dipolmoment aufweist, bringt der Einsatz aktiv abgeschirmter Magnetsysteme hier einen besonders großen Gewinn. In einer erfindungsgemäßen Anordnung ist gewährleistet, dass auch im Falle eines Quenchs des Magnetspulensystems keine Streufeldüberhöhung auftritt, da eine solche aufgrund des typischerweise großen Dipolmomentes der Hauptspule in diesem Fall besonders unerwünscht wäre.

In einer besonders bevorzugten Ausführungsform der erfindungsgemäßen Magnetanordnung wird der zusätzliche Strompfad durch ein zusätzliches, elektrisch vom Magnetspulensystem getrenntes und zu diesem koaxial angeordnetes, Spulensystem gebildet. Die Wahl eines zusätzlichen Spulensystems erlaubt eine maximale Flexibilität in der Dimensionierung des zusätzlichen Strompfades, wodurch sich ein optimaler Schutz vor einer Streufeldüberhöhung im Falle eines Quenches des Magnetspulensystems erreichen lässt.

Eine weitere bevorzugte Ausführungsform der erfindungsgemäßen Magnetanordnung zeichnet sich dadurch aus, dass der zusätzliche Strompfad aus einem, mit einem Zusatzschalter überbrückten, Teil des Magnetspulensystems besteht. Dies erlaubt einen Schutz vor Streufeldüberhöhung im Quenchfall ohne großen Produktionsaufwand.

Vorteilhaft ist auch eine Ausführungsform der erfindungsgemäßen Magnetanordnung, bei der der zusätzliche Strompfad einen kleinen Ohm'schen Widerstand $R3$ besitzt, vorzugsweise derart, dass die Zeitkonstante des zusätzlichen Strompfades $L_{C3}/R3$ mehr als eine Sekunde beträgt,- wobei $L_{C3}$ die Eigeninduktivität des zusätzlichen Strompfades ist. Dies gewährleistet, dass sich ein allfällig im zusätzlichen Strompfad induzierter Strom langsam wieder abbaut, die Zeitkonstante dieses Abbaus jedoch viel größer als die typische Zeitkonstante eines Quenchs des Magnetspulensystems ist und somit während des Quenchs die Kompensation des durch den Quench veränderten magnetischen Dipolmoments gewährleistet bleibt.

In einer weiteren vorteilhaften Ausführungsform der erfindungsgemäßen Magnetanordnung ist der zusätzliche Strompfad supraleitend. Der Vorteil dieser Variante besteht darin, dass die während eines Quenchs induzierten Ströme nicht abgebaut werden, bevor die ganze Magnetanordnung durchgequencht hat.

Vorteilhaft ist auch eine Ausführungsform der erfindungsgemäßen Magnetanordnung, bei der der zusätzliche Strompfad eine Vorrichtung zur Begrenzung des in ihm induzierten Stromes aufweist. Dies verhindert, dass unter Umständen ein derart großer Strom in den zusätzlichen Strompfad induziert wird, dass dieser beschädigt werden könnte.

Drei weitere vorteilhafte Ausführungsformen der erfindungsgemäßen Magnetanordnung zeichnen sich dadurch aus, dass der zusätzliche Strompfad Teil einer Vorrichtung ist, welche der Magnetanordnung zusätzliche Funktionalität verleiht. Diese zusätzliche Funktionalität kann insbesondere eine Driftkompensation des magnetischen Feldes der Magnetanordnung im Arbeitsvolumen, eine Shim-Vorrichtung oder eine Kompensation von externen magnetischen Feldfluktuationen sein. Der Vorteil dieser Ausführungsformen liegt darin, dass durch diese Doppelfunktionalität die gesamte Magnetanordnung kompakter gestaltet werden kann.

Eine besonders bevorzugte Ausführungsform der erfindungsgemäßen Magnetanordnung zeichnet sich dadurch aus, dass der zusätzliche Strompfad vom Magnetspulensystem induktiv entkoppelt ist. Dies hat den Vorteil, dass beim Laden oder Entladen des Magnetspulensystems kein Strom in den zusätzlichen Strompfad induziert wird, und dass nach einem Quench des Magnetspulensystems kein Reststrom im zusätzlichen Strompfad fließt auch dann, wenn der zusätzliche Strompfad supraleitend ist.

Eine besonders bevorzugte Weiterbildung der obigen Ausführungsform zeichnet sich dadurch aus, dass der zusätzliche Strompfad supraleitend und von mindestens einem der Abschnitte thermisch entkoppelt ist. Dies bewirkt, dass im Falle eines Quenchs in diesem Abschnitt die an den zusätzlichen Strompfad übertragene Wärmemenge klein ist.

Besonders bevorzugt sind Ausführungsformen, für welche die an den zusätzlichen Strompfad übertragene Wärmemenge nicht mehr als fünfzig Prozent derjenigen Wärmemenge beträgt, welche zur Auslösung eines Quenchs im zusätzlichen Strompfad nötig ist. Diese Ausführungsform ist besonders interessant für den Fall, dass der thermisch vom zusätzlichen Strompfad entkoppelte Abschnitt ein nicht verschwindendes magnetisches Dipolmoment besitzt, welches im Falle eines Quenches durch induktive Kopplung auf den zusätzlichen Strompfad übertragen wird. In diesem Fall wird gewährleistet, dass das vom zusätzlichen Strompfad erzeugte magnetische Dipolmoment nicht durch einen aufgrund thermischer Kopplung mit dem quenchenden Abschnitt erzeugten Quench des zusätzlichen Strompfades wieder verschwindet und so das Streufeld der Magnetanordnung erhöht würde.

Eine weitere bevorzugte Weiterbildung der erfindungsgemäßen Magnetanordnung zeichnet sich dadurch aus, dass der zusätzliche Strompfad supraleitend und mit mindestens einem der Abschnitte thermisch gekoppelt ist, vorzugsweise derart, dass die im Falle eines Quenchs in diesem Abschnitt an den zusätzliche Strompfad übertragene Wärmemenge mindestens dem Doppelten derjenigen Wärmemenge entspricht, welche zur Auslösung eines Quenchs im zusätzlichen Strompfad nötig ist. Diese Ausführungsform ist besonders interessant für den Fall, dass der thermisch mit dem zusätzlichen Strompfad gekoppelte Abschnitt ein verschwindendes magnetisches Dipolmoment und mit dem zusätzlichen Strompfad eine im Wesentlichen verschwindende induktive Kopplung besitzt. Dies stellt sicher, dass bei einem vollständigen Quench des Magnetspulensystems auch der zusätzliche Strompfad quencht und so die Magnetanordnung kein Streufeld mehr erzeugt.

In einer weiteren Ausführungsform zeichnet sich die Magnetanordnung dadurch aus, dass mindestens einer der Abschnitte überwiegend aus Windungen des radial inneren Teilspulensystems oder überwiegend aus Windungen des radial äußeren Teilspulensystems besteht, insbesondere derart, dass dieser Abschnitt nur aus Windungen entweder des radial inneren Teilspulensystems oder des radial äußeren Teilspulensystems besteht. Der Vorteil dieser Ausführungsform liegt darin, dass besonders empfindliche Abschnitte des Magnetspulensystems - beispielsweise die radial innersten Windungen bei Hochfeldmagneten - optimal geschützt werden können. Für solche Fälle ist meist die Bildung mehrerer kleiner Abschnitte wünschenswert, welche ausschließlich Windungen des radial inneren Teilspulensystems umfassen.

Eine weitere besonders bevorzugte Weiterbildung der erfindungsgemäßen Magnetanordnung zeichnet sich dadurch aus, dass die Magnetanordnung zusätzlich eine passive Abschirmung aus magnetischem Material umfasst. Dadurch kann eine allfällige Streufeldfluktuation während eines Quenchs unterdrückt und so die streufeldreduzierende Wirkung der erfindungsgemäßen Anordnung unterstützt werden.

Eine besonders bevorzugte Ausführungsform der erfindungsgemäßen Magnetanordnung zeichnet sich dadurch aus, dass die passive Abschirmung ein integraler Bestandteil eines Kryostaten ist, in welchem sich das Magnetspulensystem befindet. Durch den konstruktiven Miteinbezug der passiven Abschirmung in den Kryostaten lässt sich die gesamte Magnetanordnung kompakter gestalten.

Eine weitere bevorzugte Weiterbildung der erfindungsgemäßen Magnetanordnung ist dadurch gekennzeichnet, dass die passive Abschirmung im Betriebszustand des Magnetspulensystems nicht vollständig magnetisch gesättigt ist. Dies gewährleistet, dass die noch mögliche zusätzliche Magnetisierung der passiven Abschirmung eine bei einem Quench allfällig auftretende Streufeldüberhöhung kompensieren kann.

Eine besonders bevorzugte Ausführungsform der erfindungsgemäßen Magnetanordnung zeichnet sich dadurch aus, dass die passive Abschirmung aus ferromagnetischem Material, insbesondere aus Weicheisen, besteht. Durch die hohe Permeabilität, hohe Sättigungsmagnetisierung, gute kommerzielle Erhältlichkeit und den geringen Preis von Weicheisen kann so ein sehr kostengünstiger und effektiver zusätzlicher Schutz vor einer Streufeldüberhöhung während eines Quenchs der Magnetanordnung erreicht werden.

Vorteilhaft schließlich ist auch eine Ausführungsform, bei der die passive Abschirmung radial weiter außen als die radial äußerste Windung des Magnetspulensystems (M) angeordnet ist.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1     einen schematischen Vertikalschnitt durch eine radiale Hälfte der erfindungsgemäßen Magnetanordnung; und

Fig. 2     ein Verdrahtungsschema einer erfindungsgemäßen Magnetanordnung mit den Spulenabschnitten *A1, ..., An* und den dazu parallelgeschalteten Schutzelementen *R1, ..., Rl.*

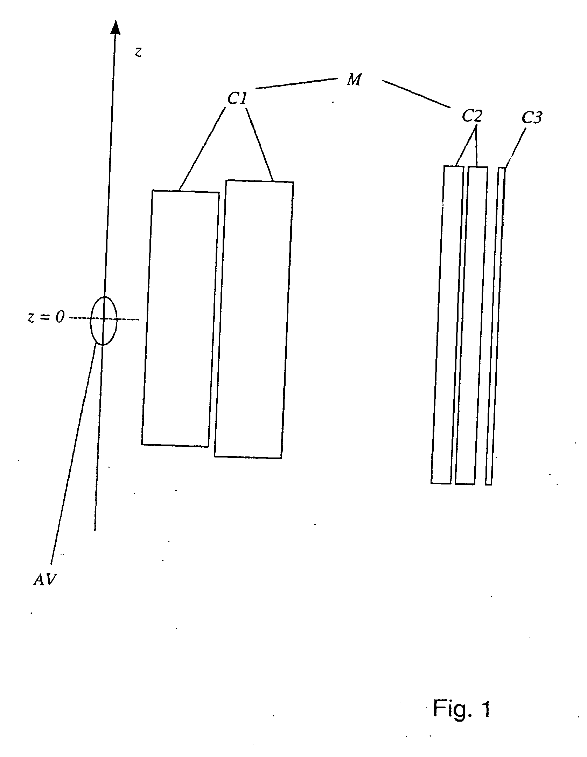

Anhand der Figur 1 wird eine erfindungsgemäße Magnetanordnung gezeigt, welche um ein Arbeitsvolumen *AV* angeordnet ist und ein Magnetspulensystem *M* mit einem radial inneren und einem radial äußeren, koaxialen Teilspulensystem *C1* und *C2* sowie einen zusätzlichen Strompfad in Form eines zusätzlichen Spulensystems *C3* umfasst.

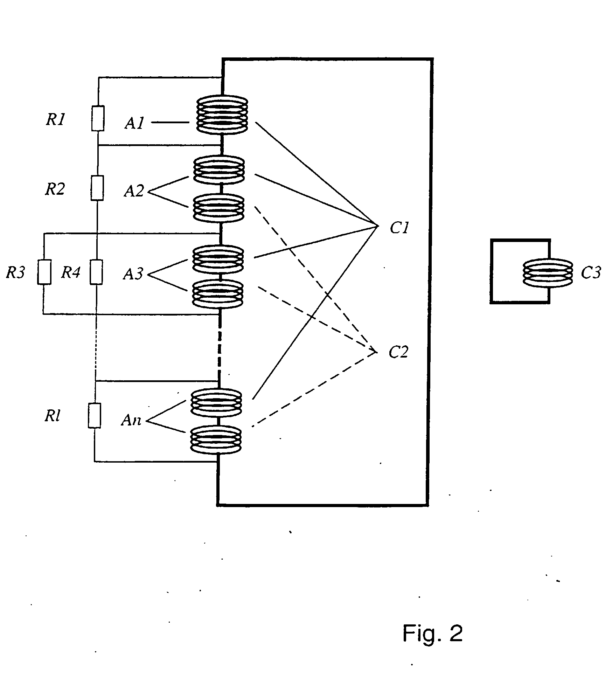

Figur 2 zeigt schematisch die Verdrahtung einer erfindungsgemäßen Magnetanordnung, insbesondere die Unterteilung des Magnetspulensystems *M* in mehrere Abschnitte *A1, ..., An* und die diesen Abschnitten parallelgeschalteten Schutzelemente *R1, ..., Rl* sowie den zusätzlichen Strompfad *C3* in der Ausführungsform eines vom Magnetspulensystem *M* getrennten zusätzlichen Spulensystems.

Im Folgenden wird die Erfindung anhand von zwei Ausführungsformen einer supraleitenden, aktiv abgeschirmten Magnetanordnung erläutert, welche im Arbeitsvolumen *AV* je ein Magnetfeld der Stärke 9 Tesla erzeugen. Als Supraleitermaterial wird Niob-Titan eingesetzt. Der Magnet wird in einem Flüssighelium-Bad betrieben bei einer Temperatur von 4.2 Kelvin.

Die erste Magnetanordnung (im Weiteren Ausführungsform ″V1″ genannt) umfasst ein Magnetspulensystem *M* mit einem radial inneren Teilspulensystem *C1* und einem radial äußeren Teilspulensystem *C2.* Hierbei besteht *C1* aus zwei konzentrischen, koaxialen Solenoidspulen *C1a* und *C1b,* welche die gleiche Polarität aufweisen und *C2* aus einer einzelnen, zu *C1* konzentrisch und koaxial angeordneter Solenoidspule mit zu *C1* entgegengesetzter Polarität. Bei der Ausführungsform *V1* handelt es sich somit um ein aktiv abgeschirmtes Magnetspulensystem. Der Magnetstrom für diese Anordnung beträgt 81.8 Ampere, die freie Innenbohrung hat einen Durchmesser von 70 Millimetern.

Mit der Variante *V1* wird eine erfindungsgemäße Variante (im Weiteren ″V2″ genannt) verglichen, welche neben dem Magnetspulensystem *M* einen zusätzlichen Strompfad *C3* in Form eines weiteren Spulensystems umfasst. Im vorliegenden Beispiel ist das Magnetspulensystem *M* identisch mit demjenigen der Variante *V1* und *C3* besteht aus einer zweilagigen Solenoidspule, welche direkt auf die äußerste Lage von *C2* gewickelt wurde. Diese zusätzliche Solenoidspule ist vom Magnetsystem *M* induktiv entkoppelt und kann beispielsweise auch als *B0*-Shim mit einer Stärke von 2.5 Millitesla pro Ampere eingesetzt werden.

Tabelle 1 zeigt einen Vergleich der wichtigsten Merkmale der Teilspulensysteme *C1* (*C1a* und *C1b*), *C2* und des zusätzlichen Strompfades *C3.*

**Tabelle 1**

|  | *C1a* | *C1b* | *C2* | *C3* |
|---|---|---|---|---|
| *ri* [Millimeter] | 38.0 | 63.5 | 238.3 | 241.8 |
| *ra* [Millimeter] | 58.5 | 107.2 | 241.8 | 243 |
| *L* [Millimeter] | 380 | 380 | 400 | 400 |
| *W* | 361 | 468 | 621 | 621 |

Tabelle fortgesetzt

|  | C1a | C1b | C2 | C3 |
|---|---|---|---|---|
| N | 26 | 62 | 6 | 2 |

In der Tabelle 1 bezeichnen:
$ri$ den Innenradius der Solenoidspule,
$ra$ den Außenradius der Solenoidspule,
$L$ die Länge der Solenoidspule,
$W$ die Anzahl Draht-Windungen auf jeder Lage der Solenoidspule,
$N$ die Anzahl Drahtlagen der Solenoidspule.

Um die Magnetanordnungen $V1$ und $V2$ gegen allfällige Drahtbeschädigungen im Falle eines Quenchs zu schützen, werden die Teilspulensysteme $C1$ und $C2$ in Abschnitte unterteilt, welche mit einem Schutzelement überbrückt werden. Die Stellen in den supraleitenden Spulensystemen, an welchen die Schutzelemente mit dem Supraleiter kontaktiert werden, liegen dabei aus produktionstechnischen Gründen mit Vorteil an jenem Spulenende, bei welchem sich auch die Ein- und Ausgänge für den Supraleiterdraht befinden. So wird vermieden, dass die Verbindungsdrähte zwischen Supraleiter und Schutzelementen auf komplizierte Weise mitten aus dem Wickelpaket herausgeführt werden müssen. Dies bedeutet aber, dass nur alle zwei Lagen eine Abschnittsunterteilung eingeführt werden kann. Die Windungen der sechslagigen Abschirmspule $C2$ in den Magnetanordnungen $V1$ und $V2$ können somit auf maximal drei verschiedene Abschnitte verteilt werden.

Damit bei einem Quench gewährleistet ist, dass keine Streufeldüberhöhung auftritt, müssen - wie in der US-A 5'644'233 gezeigt wird - die, mit Schutzelementen überbrückten, Abschnitte je Windungen aus dem Hauptspulensystem $C1$ und dem Abschirmspulensystem $C2$ umfassen, derart, dass das Dipolmoment der einzelnen Abschnitte im Wesentlichen Null ist. Gemäß diesem Stand der Technik könnten also in den Magnetanordnungen $V1$ und $V2$ maximal drei, mit Schutzelementen überbrückte, Spulenabschnitte gebildet werden, weil die Abschirmspule $C2$ keine feinere Unterteilung zulässt.

Damit die Schutzvorrichtung ihre Funktion optimal erfüllen kann, ist aber eine Spulenunterteilung in mehr Abschnitte wünschenswert. Je kleiner die mit Schutzelementen überbrückten Abschnitte sind, desto geringer ist ihre Eigeninduktivität und desto schneller kann sich ein Strom in einem gequenchten Abschnitt abbauen, so dass die Gefahr einer lokalen Drahtbeschädigung durch Überhitzung ("hot spot") minimiert werden kann.

Das Problem, dass eine Quenchschutzvorrichtung, welche - wie in der US 5'644'233 - hinsichtlich der Verhinderung einer Streufeldüberhöhung im Quenchfall optimiert ist, ihre Schutzfunktion nicht optimal erfüllt, weil die Abschnittsunterteilung zu grob gewählt werden muss, ist symptomatisch für supraleitende Hochfeldmagnete. Am Beispiel der Magnetanordnungen $V1$ und $V2$ bedeutet dies, dass für einen optimalen Spulenschutz wesentlich mehr als drei, mit Schutzelementen überbrückte, Abschnitte nötig sind, wohingegen dann das Ziel der Streufeldunterdrückung im Falle eines Quenchs nicht mehr erfüllt ist, weil nicht mehr alle Abschnitte aus Windungen der Hauptspule $C1$ und der Abschirmspule $C2$ zusammengesetzt werden können. Anhand des Beispiels der Magnetanordnungen $V1$ und $V2$ soll nun eine Abschnittsunterteilung gewählt werden, bei welcher die Windungen der Teilspule $C1b$ auf drei Abschnitte verteilt werden, wobei jeder dieser Abschnitte auch je zwei Drahtlagen der Abschirmspule $C2$ umfasst. Die Teilspule $C1a$ bildet einen vierten Abschnitt, welcher keine Windungen aus der Abschirmung $C2$ enthält (siehe Tabelle 2). Die Wahl der Abschnittsunterteilung im Teilspulensystem $C1b$ ergibt sich durch Minimierung der Streufelder der drei Abschnitte. In der Praxis würde eine feinere Spulenunterteilung bevorzugt, aber die Aufteilung auf insgesamt vier Abschnitte ist eine einfache Anordnung, anhand welcher sich die Problematik der Streufeldüberhöhung im Quenchfall und die erfindungsgemäße Lösung des Problems bereits gut diskutieren lassen. Ohne weitere Maßnahmen (Variante $V1$) birgt diese Anordnung die Gefahr einer massiven Streufeldüberhöhung, wenn in der Teilspule $C1b$ ein Quench ausbricht, welcher sich thermisch nicht sofort auf die Teilspule $C1a$ überträgt. In diesem Fall sieht man nämlich kurzfristig das volle Streufeld der Teilspule $C1a$, welches - insbesondere aufgrund der Stromüberhöhung in der Teilspule $C1a$ im Falle eines Quenches in der Teilspule $C1b$ - wesentlich größer werden kann als das Streufeld der gesamten Magnetanordnung im Betriebszustand.

Diese Gefahr ist in der erfindungsgemäßen Magnetanordnung $V2$ dadurch gebannt, dass im zusätzlichen Strompfad $C3$ ein Strom induziert wird, welcher das Streufeld der noch supraleitenden Teilspule $C1a$ kompensiert. Das Anbringen des zusätzlichen Strompfades $C3$ bewirkt also, dass die Streufeldunterdrückung im Quenchfall gewährleistet bleibt, ohne dass dabei die Schutzwirkung der Quenchschutzvorrichtung verschlechtert wird, was aufgrund einer zu groben Abschnittsunterteilung mit einer Lösung gemäß dem zitierten Stand der Technik unvermeidlich wäre.

Da der zusätzliche Strompfad $C3$ von der gesamten Magnetanordnung induktiv entkoppelt ist, wird sich der in $C3$ induzierte Strom wieder vollständig abbauen, sobald auch die Teilspule $C1a$ noch gequencht hat. So wird sichergestellt, dass nach dem vollständigen Durchquenchen des Magneten im zusätzlichen Strompfad *C3* kein Reststrom mehr fließt. Eine ähnliche Wirkung könnte beispielsweise auch mit einem kleinen Widerstand im zusätzlichen Strompfad *C3* oder mit einem Strombegrenzer erzielt werden.

Tabelle 2 zeigt die Unterteilung des Magnetspulensystems *M* in die vier Abschnitte *A1*, ..., *A4*.

**Tabelle 2**

| Abschnitt | |
|-----------|--|
| *A1* | *C1a* (Lagen 1-26) |
| *A2* | *C1b* (Lagen 1-26) & *C2* (Lagen 1-2) |
| *A3* | *C1b* (Lagen 27-46) & *C2* (Lagen 3-4) |
| *A4* | *C1b* (Lagen 47-62) & *C2* (Lagen 5-6) |

Im Folgenden soll nun das erläuterte Verhalten der Magnetanordnungen *V1* beziehungsweise *V2* im Quenchfall anhand von zwei verschiedenen Szenarien quantitativ beschrieben werden.

Zur Berechnung der im Falles eines Quenchs in den einzelnen Abschnitten beziehungsweise in *C3* induzierten Strömen benötigen wir die Induktivitätsmatrix der beschriebenen Anordnung. Diese berechnet sich zu

$$\begin{bmatrix} L_{A1} & L_{A1\leftrightarrow A2} & L_{A1\leftrightarrow A3} & L_{A1\leftrightarrow A4} & L_{A1\leftrightarrow C3} \\ L_{A1\leftrightarrow A2} & L_{A2} & L_{A2\leftrightarrow A3} & L_{A2\leftrightarrow A4} & L_{A2\leftrightarrow C3} \\ L_{A1\leftrightarrow A3} & L_{A2\leftrightarrow A3} & L_{A3} & L_{A3\leftrightarrow A4} & L_{A3\leftrightarrow C3} \\ L_{A1\leftrightarrow A4} & L_{A2\leftrightarrow A4} & L_{A3\leftrightarrow A4} & L_{A4} & L_{A4\leftrightarrow C3} \\ L_{A1\leftrightarrow C3} & L_{A2\leftrightarrow C3} & L_{A3\leftrightarrow C3} & L_{A4\leftrightarrow C3} & L_{C3} \end{bmatrix} = \begin{bmatrix} 1.65 & 2.20 & 1.58 & 1.18 & 0.16 \\ 2.20 & 5.98 & 4.70 & 3.50 & -0.10 \\ 1.58 & 4.70 & 5.12 & 4.09 & -0.04 \\ 1.18 & 3.50 & 4.09 & 4.12 & -0.02 \\ 0.16 & -0.10 & -0.04 & -0.02 & 0.57 \end{bmatrix} \text{Henry,}$$

wobei die Matrixelemente, welche Kopplungen mit *C3* beschreiben, nur für die Ausführungsform *V2* relevant sind. Wie sich aus den obigen Werten erkennen lässt, ist in der Ausführungsform *V2* der Strompfad *C3* vom Magnetspulensystem *M* induktiv entkoppelt, mit den einzelnen Abschnitten weist es jedoch eine relativ starke Kopplung auf. Da im Falle eines Quenches durch den Zusammenbruch der Supraleitung in Teilen des Spulensystems der Widerstand im jeweiligen Abschnitt stark ansteigt, wird praktisch der gesamte Magnetstrom über die diesem Abschnitt parallelgeschalteten Schutzelemente fließen. Für die Berechnung der maximal auftretenden Streufelder gilt es nun insbesondere die drei Quenchszenarien zu betrachten, bei welchen jeweils eine der drei Solenoidspulen *C1a*, *C1b* und *C2* vollständig gequencht hat. Aufgrund der Wahl der Abschnitte sind zwei dieser Fälle (*C1b* quencht oder *C2* quencht) identisch, da in beiden Fällen nur noch im Teilspulensystem *C1a* (und - falls vorhanden - im zusätzlichen Spulensystem *C3*) Strom fließen kann.

Tabelle 3 zeigt einen Vergleich der maximalen Streufelder der zwei Ausführungsformen *V1* und *V2* im Betriebszustand sowie für die zwei verschiedenen Quench-Szenarien.

**Tabelle 3**

| | Betriebszustand | Quench in *C1a* | | Quench in *C1b* oder *C2* | |
|--|--|--|--|--|--|
| | *V1 & V2* | *V1* | *V2* | *V1* | *V2* |
| *R5G* [Meter] | 0.95 | 0.90 | 0.95 | 1.65 | 0.71 |
| *B95* [Millitesla] | 0.5 | 0.4 | 0.5 | 2.5 | 0.2 |
| In der Tabelle 3 bezeichnen:<br>*R5G* den Abstand von der Magnetachse, ab welchem die Feldstärke von 0.5 Millitesla unterschritten wird,<br>*B95* den maximalen Betrag der Feldstärke der Magnetanordnung auf einer koaxialen Zylinderfläche mit Radius 0.95 Meter. | | | | | |

Der Bereich innerhalb des Abstandes *R5G* von der Magnetachse muss typischerweise von magnetfeldempfindlichen Geräten und magnetischen Materialien freigehalten werden. Im Betriebszustand der Magnetanordnungen *V1* und *V2* beträgt dieser Abstand 0.95 Meter. Es ist daher entscheidend, dass die Feldstärke von 0.5 Millitesla in diesem Abstand von der Magnetachse auch im Falle eines Quenchs der Magnetanordnung nicht überschritten wird. Diese Forderung wird in der Ausführungsform *V1* im Falle eines Quenchs in der Solenoidspule *C1b* oder *C2* nicht erfüllt. Das Streufeld kann dann bis auf das Fünffache ansteigen und der Grenzwert von 0.5 Millitesla wird erst außerhalb eines Abstandes von 1.65 Metern von der Magnetachse wieder unterschritten. Demgegenüber tritt in der erfindungsgemäßen Variante *V2* in keinem Fall eine Streufelderhöhung auf.

**Patentansprüche**

1. Magnetanordnung mit einem aktiv abgeschirmten, supraleitenden Magnetspulensystem (*M*) zur Erzeugung eines Magnetfeldes in Richtung einer z-Achse in einem auf der z-Achse um *z* = 0 angeordneten Arbeitsvolumen (*AV*) und mit einer Mehrzahl von Schutzelementen (*R1, ..., Rl)* zum Schutz des supraleitenden Magnetspulensystems (*M*) im Falle eines Zusammenbruchs der Supraleitung im Magnetspulensystem (*M*) d.h. im Falle eines Quenchs, wobei das supraleitende Magnetspulensystem (*M*) ein radial inneres Teilspulensystem (*C1*) und ein radial äußeres Teilspulensystem (*C2*) umfasst, welche elektrisch in Serie zusammengeschaltet und zueinander koaxial angeordnet sind und im Arbeitsvolumen (*AV*) je ein Magnetfeld mit entgegengesetzter Richtung entlang der *z*-Achse erzeugen, wobei der supraleitende Strompfad des Magnetspulensystems (*M*) in mehrere Abschnitte (*A1, ..., An*) unterteilt ist, welche mit jeweils mindestens einem der Schutzelemente (*R1, ..., Rl)* elektrisch parallel geschaltet sind, und wobei mindestens einer dieser Abschnitte (*A1, ..., An*) sowohl Windungen des radial inneren Teilspulensystems (*C1*) als auch Windungen des radial äußeren Teilspulensystems (*C2*) umfasst,
**dadurch gekennzeichnet, dass**
mindestens ein zusätzlicher, in sich geschlossener Strompfad (*C3*) vorgesehen ist, welcher eine nicht verschwindende Flächenwindungszahl und mit mindestens einem Abschnitt *Ai* eine von Null verschiedene induktive Kopplung $L_{Ai \leftrightarrow C3}$ aufweist, insbesondere derart, dass der Kopplungskoeffizient

$$K_i = \frac{L_{Ai \leftrightarrow C3}}{\sqrt{L_{Ai} L_{C3}}}$$

größer als 0.01 ist, wobei $L_{Ai}$ die Eigeninduktivitäten des Abschnitts *Ai* und $L_{C3}$ die Eigeninduktivität des zusätzlichen Strompfades (*C3*) bezeichnen,
dass mindestens einer der Abschnitte *(A1, ..., An),* welche mit dem zusätzlichen Strompfad (*C3*) eine von Null verschiedene induktive Kopplung aufweisen, außerdem ein von Null verschiedenes magnetisches Dipolmoment besitzt, und dass der Strom, welcher im Falle eines Quenchs dieses Abschnitts im zusätzlichen Strompfad (*C3*) induziert wird, ein magnetisches Dipolmoment erzeugt, welches demjenigen entspricht, welches dieser Abschnitt vor dem Quench aufwies.

2. Magnetanordnung nach Anspruch 1, **dadurch gekennzeichnet, dass** der zusätzliche Strompfad (*C3*) aus einem elektrisch vom Magnetspulensystem (*M*) getrennten und zu diesem koaxial angeordneten Spulensystem besteht.

3. Magnetanordnung nach Anspruch 1, **dadurch gekennzeichnet, dass** der zusätzliche Strompfad (*C3*) aus einem, mit einem Zusatzschalter überbrückten, Teil des Magnetenspulensystems (M) besteht.

4. Magnetanordnung nach einem der vorhergehenden Ansprüche, **dadurch gekennzeichnet, dass** der zusätzliche Strompfad (*C3*) Teil eines Spulensystems ist, welches in der Magnetanordnung als Shim-Vorrichtung und/oder zur Kompensation von externen magnetischen Feldfluktuationen wirkt.

5. Magnetanordnung nach einem der vorhergehenden Ansprüche, **dadurch gekennzeichnet, dass** der zusätzliche Strompfad (*C3*) vom Magnetspulensystem (*M*) induktiv entkoppelt ist.

6. Magnetanordnung nach einem der vorhergehenden Ansprüche, **dadurch gekennzeichnet, dass** der zusätzliche Strompfad (*C3*) supraleitend und von mindestens einem der Abschnitte (*A1, ..., An),* welcher im Betriebszustand ein nicht verschwindendes magnetisches Dipolmoment aufweist und mit dem zusätzlichen Strompfad (C3) induktiv gekoppelt ist, thermisch entkoppelt ist, vorzugsweise derart, dass die im Falle eines Quenchs in diesem Abschnitt an den zusätzlichen Strompfad (*C3*) übertragene Wärmemenge nicht mehr als fünfzig Prozent derjenigen Wärmemenge beträgt, welche zur Auslösung eines Quenchs im zusätzlichen Strompfad (*C3*) nötig ist, und dass der zusätzliche Strompfad (*C3*) supraleitend und mit mindestens einem der Abschnitte (*A1* ..., *An*), welcher im Betriebszustand ein verschwindendes magnetisches Dipolmoment aufweist und vom zusätzlichen Strompfad (C3) induktiv entkoppelt ist, thermisch gekoppelt ist, vorzugsweise derart, dass die im Falle eines Quenchs in diesem Abschnitt an den zusätzlichen Strompfad (*C3*) übertragene Wärmemenge mindestens dem Doppelten derjenigen Wärmemenge entspricht, welche zur Auslösung eines Quenchs im zusätzlichen Strompfad (*C3*) nötig ist.

7. Magnetanordnung nach einem der vorhergehenden Ansprüche, **dadurch gekennzeichnet, dass** mindestens einer der Abschnitte (*A1*, ..., *An*) überwiegend aus Windungen des radial inneren Teilspulensystems (*C1*) oder überwiegend aus Windungen des radial äußeren Teilspulensystems (*C2*) besteht, insbesondere derart, dass dieser Abschnitt nur aus Windungen entweder des radial inneren Teilspulensystems (*C1*) oder des radial äußeren Teilspulensystems (*C2*) besteht.

8. Magnetanordnung nach einem der vorhergehenden Ansprüche, **dadurch gekennzeichnet, dass** die Magnetanordnung zusätzlich eine passive Abschirmung aus magnetischem Material umfasst.

9. Magnetanordnung nach Anspruch 8, **dadurch gekennzeichnet, dass** die passive Abschirmung im Betriebszustand nicht vollständig magnetisch gesättigt ist.

## Claims

1. Magnet arrangement comprising an actively shielded superconducting magnet coil system (M) for generating a magnetic field in the direction of a z axis in a working volume (AV) disposed on the z axis about z=0, and with a plurality of protective elements (R1, ..., Rl) for protecting the superconducting magnet coil system (M) in case of a breakdown of the superconductivity in the magnet coil system (M), i.e. in case of a Quench, wherein the superconducting magnet coil system (M) comprises a radially inner partial coil system (C1) and a radially outer partial coil system (C2) which are electrically connected in series and arranged coaxially with respect to one another and each generating a magnetic field of opposite direction along the z axis in the working volume (AV), wherein the superconducting current path of the magnet coil system (M) is divided into several sections (A1, ..., An) each of which is electrically connected in parallel to at least one of the protective elements (R1, ..., Rl), and wherein at least one of these sections (A1, ..., An) comprises windings of the radially inner partial coil system (C1) as well as windings of the radially outer partial coil system (C2),
**characterized in that**
at least one additional closed current path (C3) is provided which has a non-vanishing areal winding number and which has a non-zero inductive coupling $L_{Ai\leftrightarrow C3}$ to at least one section Ai, preferably such that the coupling coefficient

$$K_i = \frac{L_{Ai\leftrightarrow C3}}{\sqrt{L_{Ai}L_{C3}}}$$

is larger than 0.01, wherein $L_{Ai}$ characterizes the self-inductances of the section Ai, and $L_{C3}$ characterizes the self-inductance of the additional current path (C3),
at least one of the sections (A1, ..., An) having a non-zero inductive coupling to the additional current path (C3) also has a non-zero magnetic dipole moment, and the current which, in case of a Quench of this section, is induced in the additional current path (C3) produces a magnetic dipole moment which corresponds to that of said section before the Quench.

2. Magnet arrangement according to claim 1, **characterized in that** the additional current path (C3) consists of a coil system which is not electrically connected to the magnet coil system (M) and which is arranged coaxially thereto.

3. Magnet arrangement according to claim 1, **characterized in that** the additional current path (C3) consists of a part of the magnet coil system (M) bridged with an additional switch.

4. Magnet arrangement according to any one of the preceding claims, **characterized in that** the additional current path (C3) is part of a coil system which functions as a shim device and/or compensates external magnetic field fluctuations in the magnet arrangement.

5. Magnet arrangement according to any one of the preceding claims, **characterized in that** the additional current path (C3) is inductively decoupled from the magnet coil system (M).

6. Magnet arrangement according to any one of the preceding claims, **characterized in that** the additional current path (C3) is superconducting and thermally decoupled from at least one of the sections (A1, ..., An) having a non-vanishing magnetic dipole moment during operation and being inductively coupled to the additional current path (C3), preferably such that in case of a Quench in this section, the amount of heat transferred to the additional current path (C3) is not more than 50% of the amount of heat which is required for triggering a Quench in the additional current path (C3), and that the additional current path (C3) is superconducting and thermally coupled to at least one of the sections (A1, ..., An) having a vanishing magnetic dipole moment during operation and being inductively decoupled from the additional current path (C3), preferably such that the amount of heat transferred to the additional current path (C3) during a Quench in this section corresponds to at least twice the amount of heat required for triggering a Quench in the additional current path (C3).

7. Magnet arrangement according to any one of the preceding claims, **characterized in that** at least one of the sections (A1, ..., An) consists mainly of windings of the radially inner partial coil system (C1) or mainly of windings of the radially outer partial coil system (C2), in particular such that this section consists only of windings either of the radially inner partial coil system (C1) or of the radially outer partial coil system (C2).

8. Magnet arrangement according to any one of the preceding claims, **characterized in that** the magnet arrangement additionally comprises a passive shielding of magnetic material.

9. Magnet arrangement according to claim 8, **characterized in that** the passive shielding is not completely magnetically saturated during operation.

**Revendications**

1. Agencement d'aimants comportant un système de bobines magnétiques supraconductrices (*M*) à écrantage actif pour générer un champ magnétique en direction d'un axe z dans un volume de travail (*AV*) situé sur l'axe z autour de *z = 0* et comportant une pluralité d'éléments protecteurs *(R1, ... Rl)* pour la protection du système de bobines magnétiques supraconductrices *(M)* en cas de transition résistive de la supraconductivité dans le système de bobines magnétiques *(M),* c.-à-d. en cas de quench, dans lequel le système de bobines magnétiques supraconductrices (*M*) comprend un sous-système de bobines (C1) radialement intérieur et un sous-système de bobines (C2) radialement extérieur qui sont connectés électriquement en série et disposés coaxialement et génèrent dans le volume de travail *(AV)* des champs magnétiques de sens opposés le long de l'axe *z,* dans lequel le chemin de courant supraconducteur du système de bobines magnétiques *(M)* est divisé en plusieurs sections *(A1, ... An)* qui sont connectées électriquement en parallèle avec chaque fois au moins un des éléments protecteurs *(R1, ... Rl)* et dans lequel au moins une de ces sections *(A1, ... An)* comprend aussi bien des spires du sous-système de bobines radialement intérieur *(C1)* que des spires du sous-système de bobines radialement extérieur (*C2*),
**caractérisé par le fait que**
il est prévu au moins un chemin de courant fermé (*C3*) qui présente un nombre de spires par unité de surface non négligeable et un couplage inductif $L_{Ai \leftrightarrow C3}$ différent de zéro avec au moins une section *Ai,* en particulier de telle manière que le coefficient de couplage

$$K_i = \frac{L_{Ai \leftrightarrow C3}}{\sqrt{L_{Ai} L_{C3}}}$$

soit supérieur à 0,01, $L_{Ai}$ désignant l'inductance propre de la section *Ai* et $L_{C3}$ l'inductance propre du chemin de courant supplémentaire (*C3*),
qu'au moins une des sections *(A1, ... An)* qui présentent un couplage inductif différent de zéro avec le chemin de courant supplémentaire (*C3*) possède en outre un moment dipolaire magnétique différent de zéro, et que le courant qui est induit dans le chemin de courant supplémentaire (*C3*) en cas de quench de cette section génère un moment dipolaire magnétique qui correspond à celui que cette section présentait avant le quench.

2. Agencement d'aimants selon la revendication 1, **caractérisé par le fait que** le chemin de courant supplémentaire (*C3*) est constitué d'un système de bobines électriquement isolé du système de bobines magnétiques (*M*) et disposé coaxialement à celui-ci.

3. Agencement d'aimants selon la revendication 1, **caractérisé par le fait que** le chemin de courant supplémentaire (*C3*) est constitué d'une partie du système de bobines magnétiques (*M*) court-circuitée par un commutateur supplémentaire.

4. Agencement d'aimants selon l'une des revendications précédentes, **caractérisé par le fait que** le chemin de courant supplémentaire (*C3*) fait partie d'un système de bobines qui est utilisé comme dispositif de shim dans l'agencement d'aimants et/ou pour la compensation des fluctuations de champ magnétique externes.

5. Agencement d'aimants selon l'une des revendications précédentes, **caractérisé par le fait que** le chemin de courant supplémentaire (*C3*) est découplé inductivement du système de bobines magnétiques (*M*).

6. Agencement d'aimants selon l'une des revendications précédentes, **caractérisé par le fait que** le chemin de courant supplémentaire (*C3*) est supraconducteur et découplé thermiquement d'au moins une des sections (*A1, ... An)* qui présente en régime de fonctionnement un moment dipolaire magnétique non négligeable et est couplée inductivement avec le chemin de courant supplémentaire (*C3*), de préférence de telle manière que la quantité de chaleur transmise au chemin de courant supplémentaire (*C3*) en cas de quench dans cette section ne soit pas supérieure à cinquante pour cent de la quantité de chaleur qui est nécessaire au déclenchement d'un quench dans le chemin de courant supplémentaire (*C3*), et que le chemin de courant supplémentaire (*C3*) est supraconducteur et couplé thermiquement avec au moins une des sections (*A1, ... An*) qui présente en fonctionnement un moment dipolaire magnétique négligeable et est découplée inductivement du chemin de courant supplémentaire (*C3*), de préférence de telle manière que la quantité de chaleur transmise au chemin de courant supplémentaire (*C3*) en cas de quench dans cette section corresponde au moins au double de la quantité de chaleur qui est nécessaire au déclenchement d'un quench dans le chemin de courant supplémentaire (*C3*).

7. Agencement d'aimants selon l'une des revendications précédentes, **caractérisé par le fait qu'**au moins une des sections (*A1, ... An)* est constituée principalement de spires du sous-système de bobines radialement intérieur (*C1*) ou principalement de spires du sous-système de bobines radialement extérieur (*C2*), en particulier de telle manière que cette section ne soit constituée que de spires soit du système de bobines radialement intérieur (*C1*), soit du sous-système de bobines radialement extérieur (*C2*).

8. Agencement d'aimants selon l'une des revendications précédentes, **caractérisé par le fait que** l'agencement d'aimant comprend en plus un écrantage passif en matériau magnétique.

9. Agencement d'aimants selon la revendication 8, **caractérisé par le fait que** l'écrantage passif n'est pas complètement saturé magnétiquement en régime de fonctionnement.

Fig. 1

Fig. 2